# EUROPÄISCHE PATENTSCHRIFT

(11) **EP 2 238 462 B1**
(45) Veröffentlichungstag und Bekanntmachung des Hinweises auf die Patenterteilung: **30.05.2018**
(21) Anmeldenummer: 09709124.3
(22) Anmeldetag: 08.01.2009
(51) Int. Cl.: G01R 13/02

(54) **KONFIGURIERBARES MESSGERÄT UND ENTSPRECHENDES MESSVERFAHREN**
CONFIGURABLE MEASURING MACHINE AND CORRESPONDING MEASURING METHOD
APPAREIL DE MESURE CONFIGURABLE, ET PROCÉDÉ DE MESURE CORRESPONDANT

(30) Priorität: 08.02.2008 DE 102008008138
(43) Veröffentlichungstag der Anmeldung: 13.10.2010
(73) Patentinhaber: Rohde & Schwarz GmbH & Co. KG, 81671 München (DE)
(72) Erfinder: REICH, Friedrich, 86391 Stadtbergen (DE); MÜSSIG, René, 85567 Grafing bei München (DE)
(74) Vertreter: Körfer, Thomas
(86) Internationale Anmeldenummer: PCT/EP2009/000061
(87) Internationale Veröffentlichungsnummer: WO 2009/097944

(56) Entgegenhaltungen:
- EP-A- 0 216 414
- DE-A1-102006 023 914
- US-A- 5 633 997
- US-A1- 2002 154 118
- US-A1- 2003 169 257
- US-B1- 6 571 185
- US-B2- 6 791 545

## Beschreibung

Die Erfindung betrifft ein mehrkanaliges Messgerät, insbesondere ein Oszilloskop und ein entsprechendes Messverfahren.

Herkömmlich erfolgt die Umschaltung zwischen verschiedenen Kanälen bei Messgeräten durch dedizierte, den einzelnen Kanälen zugeordnete Tasten. Dies führt jedoch häufig zu Fehlbedienungen, da eine Zuordnung des an den jeweiligen Kanal angeschlossenen Signals nicht ohne weiteres möglich ist. Erst eine tatsächliche Messung und Darstellung des jeweiligen Signals lässt die Art des Signals erkennen, und erlaubt so eine Zuordnung. Damit ist eine Fehlbedienungen häufig, und eine Vermeidung einer solchen nimmt nennenswert Zeit des Nutzers in Anspruch.

In der US 6,791,545 B2 wird ein Oszilloskop und ein entsprechendes Messverfahren gezeigt, welche eine Vorschau auf zu erwartende Anzeigen des Oszilloskops ermöglichen. Es wird jedoch lediglich eine Vorschau auf unterschiedliche Messverfahren, wie zum Beispiel eine Histogramm-Messung oder eine Amplituden-Messung gezeigt. Der Anschluss mehrerer verschiedener Signale an das Oszilloskop und die Darstellung zugehöriger Vorschau-Bilder ist nicht offenbart.

Weiterhin zeigt die DE 10 2006 023 914 A1 ein Messgerät, welches Vorschauanzeigen mehrerer unterschiedlicher Signale gleichzeitig darstellt. Dabei erfolgt die Anzeige der verkleinerten Darstellungen der Diagramme jedoch in einem abgetrennten Anzeigebereich. Dies führt zu einer verkleinerten Darstellung der Diagramme. Darüber hinaus können die verschiedenen Diagramme nicht frei platziert werden. Die Diagramme können lediglich an vorbestimmten Positionen der Anzeige angeordnet werden. Auch eine überlagerte Anzeige von Diagrammen, welche Vergleiche der Signale erlaubt, wird nicht gezeigt.

Der Erfindung liegt die Aufgabe zu Grunde, ein Messgerät und ein Messverfahren zu schaffen, welche eine schnelle zuverlässige Messung der Signale an mehreren verschiedenen Kanälen eines Messgerätes ermöglichen. Insbesondere eine eindeutige Zuordnung der jeweiligen Signale zu den Kanälen des Messgerätes und eine sehr gute Ablesbarkeit der Messergebnisse sind dabei wichtig.

Die Aufgabe wird erfindungsgemäß für das Messgerät durch die Merkmale des unabhängigen Anspruchs 1 und für das Messverfahren durch die Merkmale des unabhängigen Anspruchs 17 gelöst. Vorteilhafte Weiterbildungen sind Gegenstand der hierauf rückbezogenen Unteransprüche.

Das erfindungsgemäße Messgerät verfügt über eine Anzeigeeinrichtung, eine Verarbeitungseinrichtung und zumindest einen Messkanal. Die Verarbeitungseinrichtung misst das Messsignal des zumindest einen Messkanals. Die Anzeigeeinrichtung stellt das gemessene Signal des zumindest einen Messkanals als Diagramme dar. Dabei sind mehrere Diagramme gleichzeitig darstellbar. Die Anzeigeeinrichtung stellt zusätzlich Vorschaudiagramme dar. Die Vorschaudiagramme sind verkleinerte Darstellungen der Diagramme. Die mehreren Diagramme sind überlagert und/oder nebeneinander und/oder untereinander darstellbar. Die mehreren Diagramme sind an unterschiedlichen, bevorzugt beliebigen, Positionen der Anzeigeeinrichtung darstellbar. So kann an dem Vorschaudiagramm das zu erwartende Bild des jeweiligen Diagramms abgelesen werden. Vor Darstellung des Diagramms ist eine Beurteilung der Messwerte möglich. Eine große Informationsmenge kann gleichzeitig dargestellt werden. Vergleiche zwischen verschiedenen Diagrammen sind möglich. Ein Hin- und Herschalten zwischen verschiedenen Diagrammen kann vermieden werden. Durch die beliebige Positionierung ist eine große Flexibilität des Einsatzes möglich.

Die Verarbeitungseinrichtung leitet bevorzugt mehrere Diagramme aus dem Messsignal des zumindest einen Messkanals ab. So sind unterschiedliche Darstellungen eines Signals möglich, was zu großer Übersichtlichkeit und einer großen Menge darstellbarer Informationen führt.

Die Verarbeitungseinrichtung misst bevorzugt mehrere Messsignale mehrerer Messkanäle. So können verschiedene Signale miteinander verglichen werden.

Die Verarbeitungseinrichtung leitet vorteilhafterweise ein Messsignal gleichzeitig aus den Messsignalen mehrerer Messkanäle ab. So sind z.B. Summen oder Differenzen mehrerer anliegender Signale in einem gemeinsamen Diagramm darstellbar. Dies erhöht die Lesbarkeit der Informationen für den Bediener und spart zusätzliche Verarbeitungsschritte ein.

Die Vorschaudiagramme werden bevorzugt bei Bedarf ausgeblendet. So wird auf der Anzeigeeinrichtung Platz zur Darstellung der Diagramme gewonnen.

Die Vorschaudiagramme sind bevorzugt vereinfachte Darstellungen der Diagramme. Vorteilhafterweise sind die Vorschaudiagramme Echtzeit-Abbilder der Diagramme. So ist eine große Übersichtlichkeit der Vorschaudiagramme erreichbar, da die verkleinerten Diagramme, die Vorschaudiagramme, weniger Informationen enthalten als die Diagramme. Weiterhin erlaubt die Echtzeit-Darstellung eine zuverlässige Einschätzung des zu erwartenden Diagramms. Die Auswahl der darzustellenden Diagramme erfolgt bevorzugt durch Auswahl der entsprechenden Vorschaudiagramme. Eine erneute Auswahl eines Vorschaudiagramms, bei bereits erfolgender Darstellung des zugehörigen Diagramms löst bevorzugt eine Entfernung des zugehörigen Diagramms von der Anzeigeeinrichtung aus. So ist eine Auswahl des zu betrachtenden Diagramms vor der Darstellung verschiedener Diagramme möglich. Eine Übersicht mehrerer Vorschaudiagramme erlaubt dem Benutzer eine einfache und schnelle Auswahl. Eine einfache, intuitive Abwahl eines Diagramms ist so gewärleistet. Die Anordnung der Diagramme erfolgt auf der Anzeigeeinrichtung durch Positionierung der Vorschaudiagramme an bestimmten Positionen der Anzeigeeinrichtung. So kann intuitiv die Aufteilung der Anzeigeeinrichtung eingestellt werden. Eine Schulung der Nutzer des Messgeräts ist nicht notwendig.
Die Anzeigeeinrichtung ist bevorzugt ein berührungsempfindlicher Bildschirm. Die Auswahl und Positionierung der Vorschaudiagramme auf der Anzeigeeinrichtung kann bevorzugt durch Berührung und Verschiebung der Vorschaudiagramme erfolgen. So kann besonders einfach die Aufteilung der Diagramme auf der Anzeigeeinrichtung eingestellt werden. Eine sichere und intuitive Zuordnung der Diagramme zu den Signalen ist gewährleistet.

Das Messgerät verfügt bevorzugt über ein Zeigeinstrument (Mouse). Die Auswahl und Positionierung der Vorschaudiagramme auf der Anzeigeeinrichtung kann bevorzugt durch Auswahl und Verschiebung der Vorschaudiagramme mit dem Zeigeinstrument erfolgen. So kann der Nutzer das sehr verbreitete Eingabeinstrument zur Anordnung der Diagramme auf der Anzeigeeinrichtung nutzen. Eine einfache und intuitive Bedienung ist so gewährleistet.

Bevorzugt erfolgt die Positionierung der Diagramme durch Auswahl und Verschiebung der Vorschaudiagramme in bestimmte Bereiche der Anzeigeeinrichtung oder in bestimmte Bereiche bereits dargestellter Diagramme. Eine Verschiebung eines Vorschaudiagramms auf der Anzeigeeinrichtung, ohne vorherige Darstellung eines Diagramms, bewirkt bevorzugt die Darstellung eines dem Vorschaudiagramm entsprechenden Diagramms auf weitgehend der gesamten Anzeigeeinrichtung. Eine Verschiebung eines Vorschaudiagramms in die Mitte eines bereits dargestellten ersten Diagramms bewirkt bevorzugt eine Überlagerung des ersten Diagramms und des dem Vorschaudiagramm entsprechenden zweiten Diagramms. Eine Verschiebung eines Vorschaudiagramms an den Rand eines bereits dargestellten ersten Diagramms bewirkt eine Verkleinerung des ersten Diagramms und eine Darstellung des dem Vorschaudiagramm entsprechenden zweiten Diagramms auf der durch die Verkleinerung frei gewordenen Fläche. Die Verkleinerung erfolgt bevorzugt dergestalt, dass die Darstellung des zweiten Diagramms auf der Seite des Randes des ersten Diagramms erfolgt, an welchen das Vorschaudiagramm verschoben wurde. So ist eine eindeutige, für den Nutzer leicht nachvollziehbare Anordnung der Diagramme gewährleistet. Eine einfache und schnelle Bedienung des Messgeräts ist möglich.

Bei Darstellung eines Diagramms ist bevorzugt das dem jeweiligen Diagramm entsprechende Vorschaudiagramm ausgeblendet oder durch Konfigurationsparameter ersetzt. So ist eine sichere Zuordnung der dargestellten Diagramme zu den Kanälen des Messgeräts gewährleistet. Weiterhin sind so für den Nutzer einfach zuordenbar Konfigurationsparameter der dargestellten Signale ablesbar.

Vorteilhafterweise stellt die Anzeigeeinrichtung die Vorschaudiagramme zu einem von der Verarbeitungseinrichtung festgelegten beliebigem Grad transparent dar. Die Anzeigeeinrichtung stellt die Vorschaudiagramme bevorzugt den Diagrammen überlagert dar. So ist die Sichtbarkeit der vollständigen Signale der unterschiedlichen Diagramme gewährleistet. Gegenüber einer Darstellung der Vorschaudiagramme in einem eigenen abgesetzten Bereich der Anzeigeeinrichtung können die Diagramme vergrößert dargestellt werden, was die Übersichtlichkeit und Lesbarkeit verbessert.

Das Messgerät verfügt weiterhin über eine Bedieneinheit mit zumindest einem Bedienelement. Jedes dargestellte Diagramm ist in einer, von den Farben der Darstellungen der übrigen Diagramme unterscheidbaren Farbe dargestellt. Das zumindest eine Bedienelement ist mit den Farben der Diagramme zumindest ähnlichen Farben beleuchtbar und/oder hinterleuchtbar. So ist eine sehr einfache Zuordnung des Bedienelements zu einzelnen dargestellten Diagrammen möglich.

Die Bedieneinheit des Messgeräts verfügt bevorzugt über mehrere Bedienelemente. Die mehreren Bedienelemente sind bevorzugt mit, den Farben der Diagramme zumindest ähnlichen Farben beleuchtbar und/oder hinterleuchtbar. Genau ein von dem Messgerät dargestelltes Diagramm ist bevorzugt ein aktives Diagramm. Das zuletzt platzierte oder veränderte Diagramm ist bevorzugt das aktive Diagramm. Zumindest ein Bedienelement ist bevorzugt in einer der Farbe des aktiven Diagramms ähnlichen Farbe beleuchtet oder hinterleuchtet. So ist eine einfache Zuordnung der jeweiligen Bedienelemente zu dem gerade aktiven Diagramm möglich.

Das aktive Diagramm ist bevorzugt durch Auswahl eines Diagramms auf der Anzeigeeinrichtung wechselbar. Mit dem Wechsel des aktiven Diagramms wechselt bevorzugt die Beleuchtung oder Hinterleuchtung zumindest eines Bedienelements auf eine der Farbe des aktiven Diagramms ähnliche Farbe wechselt. So ist gewährleistet, dass stets die korrekten Bedienelemente in der Farbe des aktuell aktiven Diagramms beleuchtet oder hinterleuchtet werden.

Nachfolgend wird die Erfindung anhand der Zeichnung, in der ein vorteilhaftes Ausführungsbeispiel der Erfindung dargestellt ist, beispielhaft beschrieben. In der Zeichnung zeigen:
- Fig. 1: eine Darstellung eines beispielhaften Messgeräts;
- Fig. 2: eine Darstellung der Anzeigeeinrichtung eines ersten Ausführungsbeispiels des erfindungsgemäßen Messgeräts;
- Fig. 3: eine Darstellung der Anzeigeeinrichtung eines zweiten Ausführungsbeispiels des erfindungsgemäßen Messgeräts;
- Fig. 4: eine Darstellung der Anzeigeeinrichtung eines dritten Ausführungsbeispiels des erfindungsgemäßen Messgeräts;
- Fig. 5: eine Darstellung der Anzeigeeinrichtung eines vierten Ausführungsbeispiels des erfindungsgemäßen Messgeräts;
- Fig. 6: eine Darstellung der Anzeigeeinrichtung eines fünften Ausführungsbeispiels des erfindungsgemäßen Messgeräts;
- Fig. 7: eine Darstellung der Anzeigeeinrichtung eines sechsten Ausführungsbeispiels des erfindungsgemäßen Messgeräts;
- Fig. 8: eine Darstellung der Anzeigeeinrichtung eines siebten Ausführungsbeispiels des erfindungsgemäßen Messgeräts;
- Fig. 9: eine Darstellung der Anzeigeeinrichtung eines achten Ausführungsbeispiels des erfindungsgemäßen Messgeräts, und

- Fig. 10: eine Darstellung der Anzeigeeinrichtung eines neunten Ausführungsbeispiels des erfindungsgemäßen Messgeräts.

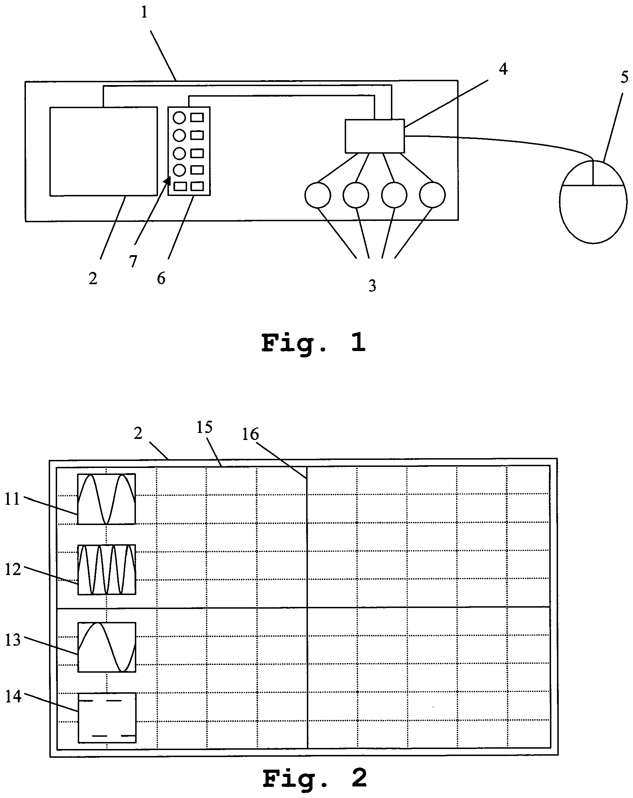

Anhand der Fig. 1 wird der generelle Aufbau eines Messgeräts skizziert. Anhand der Fig. 2 - 10 wird der Aufbau und die Funktionsweise des erfindungsgemäßen Messgeräts und die Funktionsweise des erfindungsgemäßen Messverfahrens gezeigt. Identische Elemente wurden in ähnlichen Abbildungen zum Teil nicht wiederholt dargestellt und beschrieben.

In Fig. 1 wird eine Darstellung eines beispielhaften Messgeräts 1 gezeigt. Ein Messgerät 1 verfügt über eine Anzeigeeinrichtung 2, eine Verarbeitungseinrichtung 4, und eine Mehrzahl an Kanälen. Auch eine einkanalige Ausführung des Messgeräts ist denkbar. Über eine Mehrzahl von Anschlüssen 3 werden Signale an das Messgerät 1 übertragen. Die Verarbeitungseinrichtung 4 misst die Signale und stellt die Messergebnisse in Form von Diagrammen auf der Anzeigeeinrichtung 2 dar. Die Verarbeitungseinrichtung 4 führt ebenfalls vor der Anzeige durch die Anzeigeeinrichtung 2 stattfindende Berechnungen an den Messergebnissen durch. So ist z.B. eine Verrechnung mehrerer Messsignale zu einem Messsignal denkbar. Mittels eines Zeigeinstruments 5 und einer Bedieneinheit 6 mit mehreren Bedienelementen 7 wird das Messgerät 1 gesteuert. Weiterhin ist eine Steuerung des Messgeräts 1 durch die berührungsempfindliche Anzeigeeinrichtung 2 möglich.

Fig. 2 zeigt eine Darstellung der Anzeigeeinrichtung 2 eines ersten Ausführungsbeispiels des erfindungsgemäßen Messgeräts 1. Auf der Anzeigeeinrichtung 2 ist ein Diagramm 15 dargestellt. Das Diagramm 15 enthält in dieser Darstellung lediglich das Koordinatensystem 16. Dem Diagramm überlagert ist eine Mehrzahl an Vorschaudiagrammen 11, 12, 13, 14 dargestellt. Die Vorschaudiagramme 11, 12, 13, 14 stellen dabei die an den einzelnen Kanälen des Geräts gemessenen Signale in einer vereinfachten und verkleinerten Form dar. Die Vorschaudiagramme 11, 12, 13, 14 sind dabei Echtzeit-Abbildungen zu erwartender Diagramme. Da das Diagramm 15 gegenwärtig kein Signal darstellt, werden die Vorschaudiagramme 11, 12, 13, 14 sämtlicher verfügbarer Kanäle dargestellt. Die Beschriftung des Diagramms 15 und das Koordinatensystem 16 sind dabei in einer neutralen Farbe dargestellt, da in dem Diagramm 15 kein Signal dargestellt wird.

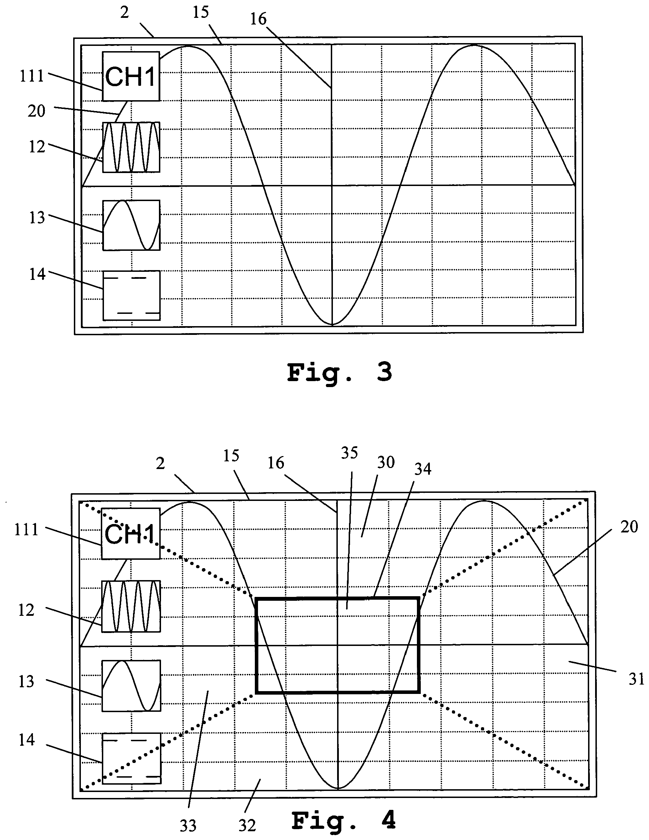

In Fig. 3 wird eine Darstellung der Anzeigeeinrichtung 2 eines zweiten Ausführungsbeispiels des erfindungsgemäßen Messgeräts 1 gezeigt. Durch Auswahl eines der Vorschaudiagramme 11, 12, 13, 14 wird die Darstellung des zugeordneten Signals 20 als Diagramm 15 bewirkt. Die Auswahl erfolgt dabei mittels eines Zeigeinstruments 5 oder der berührungsempfindlichen Anzeigeeinrichtung 2. Auf der Anzeigeeinrichtung 2 des Messgerätes 1 wird nun das Diagramm 15 dargestellt. Das Diagramm 15 enthält das Koordinatensystem 16 und das Signal 20. Das Signal 20, die Beschriftung des Diagramms 15 und das Koordinatensystem 16 sind dabei in derselben Farbe dargestellt. Dem Diagramm 15 überlagert dargestellt sind eine Mehrzahl von Vorschaudiagrammen 12, 13, 14. Statt dem Vorschaudiagramm 11 aus Fig. 2 wird hier die Kanalnummer 111 dargestellt, da das Signal 20 dem Vorschaudiagramm 11 entspricht. So ist deutlich, welcher Kanalnummer 111 das dargestellte Signal 20 entspricht. Eine Darstellung der Kanalnummer 111 und des zugehörigen Signals 20 in derselben Farbe erleichtert diese Zuordnung zusätzlich. Neben der Kanalnummer 111 ist die Darstellung zusätzlicher Signal-Konfigurationsparameter an Stelle des Vorschaudiagramms 11 denkbar.

Fig. 4 zeigt eine Darstellung der Anzeigeeinrichtung 2 eines dritten Ausführungsbeispiels des erfindungsgemäßen Messgeräts 1. Wird neben dem ersten Vorschaudiagramm 11 ein weiteres Vorschaudiagramm 12, 13, 14 ausgewählt, so wird eine Platzierungshilfe 34 dem gegenwärtigen Diagramm 15 überlagert dargestellt. Durch eine Platzierung des ausgewählten Vorschaudiagramms 12, 13, 14 in dem mittleren Sektor 35 der Platzierungshilfe 34 wird das dem ausgewählten Vorschaudiagramm 12, 13, 14 zugeordnete Signal dem bereits dargestellten Signal 20 überlagert dargestellt. Eine Platzierung des ausgewählten Vorschaudiagramms 12, 13, 14 in einem der seitlichen Sektoren 30, 31, 32, 33 führt zu einer Verkleinerung des bereits dargestellten Diagramms 15 und einer Platzierung des dem ausgewählten Vorschaudiagramm 12, 13, 14 zugeordneten Diagramms auf der entsprechenden Seite des bereits dargestellten Diagramms 15. Eine teilweise transparente Darstellung der Vorschaudiagramme 12, 13, 14 bzw. der zugeordneten Kanalnummern oder Konfigurationsparameter zur Erhöhung der Übersichtlichkeit ist darüber hinaus denkbar.

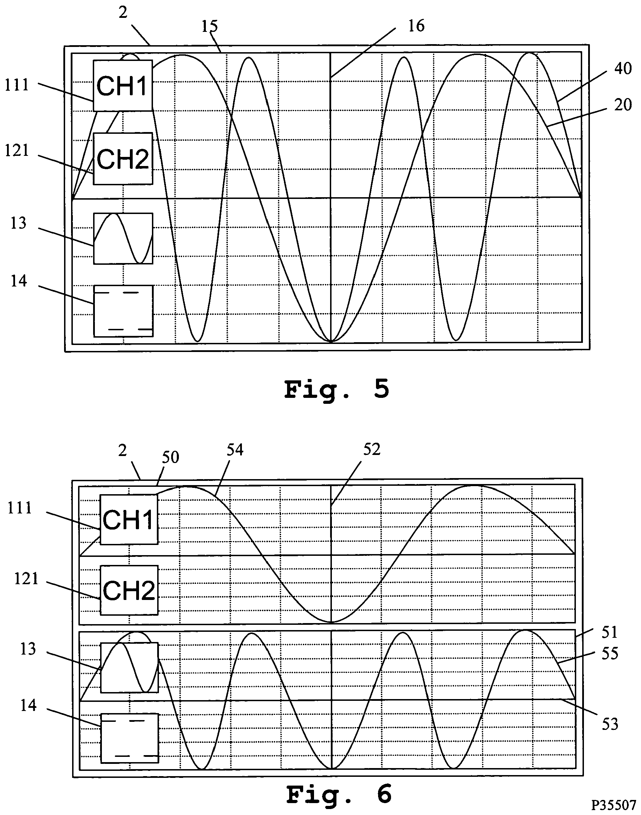

In Fig. 5 wird eine Darstellung der Anzeigeeinrichtung 2 eines vierten Ausführungsbeispiels des erfindungsgemäßen Messgeräts 1 gezeigt. Hier wird das Ergebnis der Auswahl des Vorschaudiagramms 12 aus Fig. 4 und einer Platzierung desselben in dem mittleren Sektor 35 der Platzierungshilfe 34 dargestellt. Nach der Platzierung des zweiten Signals 40, welches dem Vorschaudiagramm 12 aus Fig. 4 entspricht, wird es dem Signal 20 überlagert in einem weiteren Diagramm dargestellt. Da die Diagramme hier vollständig überlagert sind, werden sie mit der gemeinsamen Referenz 15 bezeichnet. Statt den Vorschaudiagrammen 11, 12 aus Fig. 2, welche den beiden nun dargestellten Signalen 20, 40 entsprechen, werden die Kanalnummern 111, 121 dargestellt. Dabei erfolgt die Darstellung des jeweiligen Signals 20, 40 in derselben Farbe wie die Darstellung der der Kanalnummer 111, 121. So ist eine leichte Zuordnung auch bei mehreren dargestellten Signalen gewährleistet. Vor der Platzierung des zweiten Signals 40 waren das ursprünglich dargestellte Signal 20 und das entsprechende Diagramm aktiv. Folglich war das Signal 20, die Beschriftung der Diagramme 15 und das Koordinatensystem 16 in derselben Farbe dargestellt. Nach der Platzierung des zweiten Signals 40 in den Diagrammen 15 wechselt das aktive Signal bzw. Diagramm auf das zuletzt platzierte Signal 40 und sein zugehöriges Diagramm 15. Damit ändert sich auch die Farbe der Beschriftung der Diagramme 15 und des Koordinatensystems 16.

Fig. 6 zeigt eine Darstellung der Anzeigeeinrichtung 2 eines fünften Ausführungsbeispiels des erfindungsgemäßen Messgeräts 1. Hier wird das Ergebnis der Auswahl des Vorschaudiagramms 12 aus Fig. 4 und einer Platzierung desselben in dem unteren Sektor 32 der Platzierungshilfe 34 dargestellt. Das Diagramm 15 aus Fig. 4 ist hier als verkleinertes Diagramm 50 dargestellt. Zusätzlich ist darunter ein weiteres Diagramm 51 dargestellt. In dem ersten Diagramm 50 ist das dem ersten Vorschaudiagramm 11 aus Fig. 2 zugeordnete Signal 54 dargestellt. In dem zweiten Diagramm 51 ist das dem zweiten Vorschaudiagramm 12 aus Fig. 4 zugeordnete Signal 55 dargestellt. Jedes der dargestellten Diagramme 50, 51 verfügen dabei über ein eigenes Koordinatensystem 52, 53. Auch hier werden die beiden entsprechenden Vorschaudiagramme 11, 12 aus Fig. 4 nicht mehr dargestellt. Stattdessen wird auch hier die jeweilige Nummer 111, 121 des zugeordneten Kanals dargestellt. Auch hier werden die Kanalnummern 111, 121 und die entsprechenden Signale 54, 55 in derselben Farbe dargestellt. Die Beschriftungen der Diagramme 50, 51 und die Koordinatensysteme 52, 53 werden hier ebenfalls in der Farbe des jeweils dargestellten aktiven Diagramms 50, 51 dargestellt. Da hier in jedem Diagramm 50, 51 lediglich ein Signal 54, 55 dargestellt ist, ist die Farbe dieses Signals 54, 55 die dem jeweiligen Diagramm 50, 51 zugeordnete Farbe.

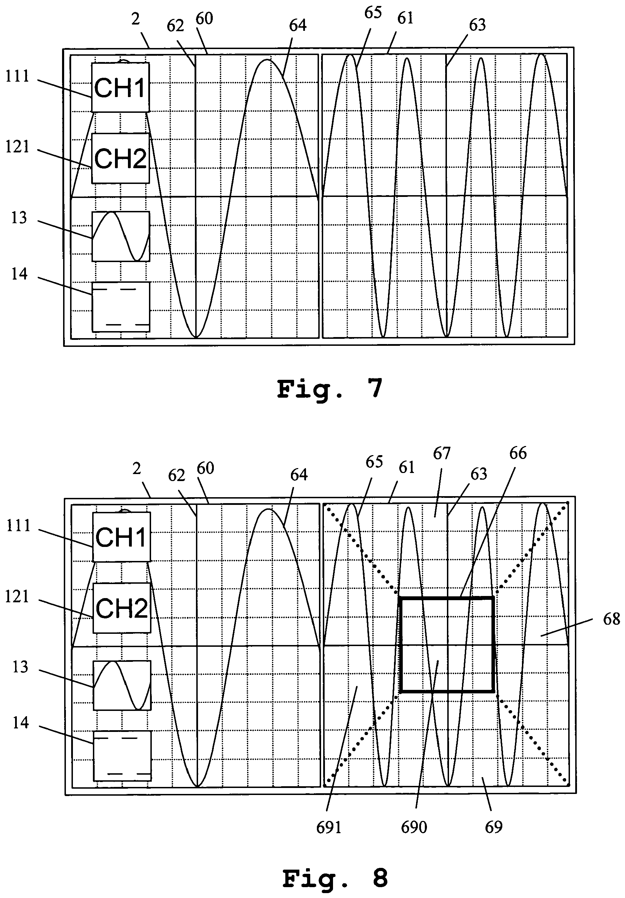

In Fig. 7 wird eine Darstellung der Anzeigeeinrichtung 2 eines sechsten Ausführungsbeispiels des erfindungsgemäßen Messgeräts 1 gezeigt. Hier wird das Ergebnis der Auswahl des Vorschaudiagramms 12 aus Fig. 4 und einer Platzierung desselben in dem rechten Sektor 31 der Platzierungshilfe 34 dargestellt. Das Diagramm 15 aus Fig. 4 ist hier als verkleinertes Diagramm 60 dargestellt. Zusätzlich ist daneben ein zweites Diagramm 61 dargestellt. In dem ersten Diagramm 60 ist das dem ersten Vorschaudiagramm 11 zugeordnete Signal 64 dargestellt. In dem zweiten Diagramm 61 ist das dem zweiten Vorschaudiagramm 12 zugeordnete Signal 65 dargestellt. Jedes der dargestellten Diagramme 60, 61 verfügen dabei über ein eigenes Koordinatensystem 62, 63. Auch hier werden die beiden entsprechenden Vorschaudiagramme 11, 12 aus Fig. 4 nicht mehr dargestellt. Stattdessen wird auch hier die jeweilige Nummer 111, 121 des zugeordneten Kanals dargestellt. Die farbliche Gestaltung entspricht der anhand Fig. 6 gezeigten Gestaltung.

Fig. 8 zeigt eine Darstellung der Anzeigeeinrichtung 2 eines siebten Ausführungsbeispiels des erfindungsgemäßen Messgeräts 1. Soll ein weiteres Signal in Form eines Diagramms auf der Anzeigeeinrichtung 2 dargestellt werden, wird ein weiteres Vorschaudiagramm 13 ausgewählt. Durch vorläufige Platzierung des Vorschaudiagramms 13 über dem Diagramm 61 erscheint die Platzierungshilfe 66 dem Diagramm 61 überlagert. Wie bereits in Fig. 4 erläutert, ist eine endgültige Positionierung des Vorschaudiagramms 13 in einem der fünf Sektoren 67, 68, 69, 690, 691 möglich und löst jeweils eine unterschiedliche Anordnung der Diagramme auf der Anzeigeeinrichtung 2 aus.

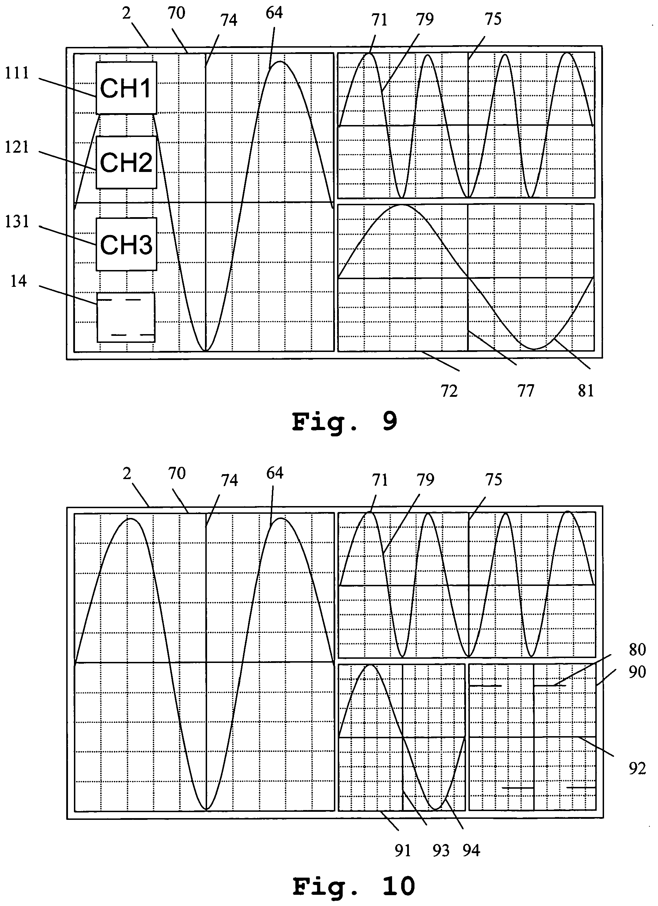

Fig. 9 zeigt eine Darstellung der Anzeigeeinrichtung 2 eines achten Ausführungsbeispiels des erfindungsgemäßen Messgeräts 1. Bei Platzierung des dritten Vorschaudiagramms 13 aus Fig. 8 in dem unteren Sektor 69 der Platzierungshilfe 66 wird das Diagramm 61 aus Fig. 8 verkleinert und als Diagramm 71 dargestellt. Dieses enthält das Signal 79 und das Koordinatensystem 75. In dem frei gewordenen Raum auf der Anzeigeeinrichtung 2 wird das zusätzliche Diagramm 72 dargestellt. Das Diagramm 72 enthält das Signal 81 und das Koordinatensystem 77. Wie bereits zuvor erläutert, wird das Vorschaudiagramm 13 nicht länger dargestellt. Stattdessen wird die Kanalnummer 131 farblich passend zu dem Signal 81 gezeigt. Wie bereits anhand der übrigen Figuren gezeigt, entspricht auch in diesem Ausführungsbeispiel die Farbe der Koordinatensysteme 74, 75, 77, der Beschriftungen und der Vorschaudiagramme 14 bzw. Kanalnummern 111, 121, 131 den Farben der Signale 64, 79, 81 in den Diagrammen 70, 71, 72.

Fig. 10 zeigt eine Darstellung der Anzeigeeinrichtung 2 eines neunten Ausführungsbeispiels des erfindungsgemäßen Messgeräts 1. Wird von dem in Fig. 9 dargestellten Zustand ausgehend das vierte Vorschaudiagramm 14 aus Fig. 9 ausgewählt und in der rechten unteren Ecke der Anzeigeeinrichtung 2 platziert, so ergibt sich die hier dargestellte Anordnung von Diagrammen 70, 71, 90, 91 auf der Anzeigeeinrichtung 2. Jedes der Diagramme 70, 71, 90, 91 verfügt dabei über ein eigenes Koordinatensystem 74, 75, 92, 93. In jedem der Diagramme 70, 71, 90, 91 wird ein eigenes Signal 64, 79, 80, 94 dargestellt. In diesem Ausführungsbeispiel wurden die Vorschaudiagramme und Kanalnummern ausgeblendet, um mehr Raum für die Darstellung der Diagramme 70, 71, 90, 91 zu gewinnen. Auch eine alternative transparente Darstellung wäre denkbar.

Um ein Diagramm wieder auszublenden kann das gerade aktive Diagramm mittels eines der Bedienelemente 7 ausgeblendet werden. Alternativ kann durch erneute Auswahl eines Vorschaudiagramms bzw. einer Kanalnummer, wenn das zugeordnete Diagramm dargestellt wird, das jeweilige Diagramm ausgeblendet werden. Würde dabei das letzte Diagramm an einer Position ausgeblendet, d.h. ist kein überlagertes Diagramm vorhanden, wird das entsprechende Diagramm von der Anzeigeeinrichtung 2 entfernt und nach Möglichkeit das Diagramm, welches zu Gunsten des auszublendenden Diagramms verkleinert wurde in seiner ursprünglichen Größe wiederhergestellt. Ist dies nicht möglich, wird das benachbarte Diagramm entsprechend vergrößert. Ist das auszublendende Diagramm das einzige von der Anzeigeeinrichtung 2 dargestellte Diagramm, wird es nicht ausgeblendet, sondern wird weiterhin dargestellt, wobei das Signal des Diagramms ausgeblendet wird.

Die Erfindung ist nicht auf das dargestellte Ausführungsbeispiel beschränkt. Wie bereits erwähnt, können unterschiedliche Messgeräte eingesetzt werden. Sowohl Oszilloskope als auch Spektrumanalysatoren sind beispielsweise denkbar. Alle vorstehend beschriebenen Merkmale oder in den Figuren gezeigten Merkmale sind im Rahmen der Erfindung beliebig miteinander kombinierbar.

## Patentansprüche

1. Messgerät (1) mit einer Anzeigeeinrichtung (2), einer Verarbeitungseinrichtung (4) und zumindest einem Messkanal,
wobei die Verarbeitungseinrichtung (4) das Messsignal (20, 40, 54, 55, 64, 65, 79, 80, 81, 94) des zumindest einen Messkanals misst,
wobei die Anzeigeeinrichtung (2) das Messsignal (20, 40, 54, 55, 64, 65, 79, 80, 81, 94) des zumindest einen Messkanals als Diagramm (15, 50, 51, 60, 61, 70, 71, 72, 90, 91) darstellt,
wobei mehrere Diagramme (50, 51, 60, 61, 70, 71, 72, 90, 91) gleichzeitig darstellbar sind,
wobei mit der Anzeigeeinrichtung (2) zusätzlich Vorschaudiagramme (11, 12, 13, 14) darstellbar sind,
wobei die Vorschaudiagramme (11, 12, 13, 14) verkleinerte Darstellungen der Diagramme (15, 50, 51, 60, 61, 70, 71, 72, 90, 91) sind,
wobei das Messgerät (1) weiterhin über eine Bedieneinheit (6) mit zumindest einem Bedienelement (7) verfügt, wobei die mehreren Diagramme (50, 51, 60, 61, 70, 71, 72, 90, 91) überlagert und/oder nebeneinander und/oder untereinander darstellbar sind,
wobei die mehreren Diagramme (50, 51, 60, 61, 70, 71, 72, 90, 91) an unterschiedlichen Positionen der Anzeigeeinrichtung (2) darstellbar sind,
und wobei die Anordnung der Diagramme (15, 50, 51, 60, 61, 70, 71, 72, 90, 91) auf der Anzeigeeinrichtung (2) durch Positionierung der Vorschaudiagramme (11, 12, 13, 14) in bestimmten Bereichen (30, 31, 32, 33, 35, 67, 68, 69, 690, 691) der Anzeigeeinrichtung (2) erfolgt,
**dadurch gekennzeichnet,**
**dass** jedes dargestellte Diagramm (15, 50, 51, 60, 61, 70, 71, 72, 90, 91) in einer von den Farben der Darstellungen der übrigen Diagramme (15, 50, 51, 60, 61, 70, 71, 72, 90, 91) unterscheidbaren Farbe dargestellt ist,
**dass** das zumindest eine Bedienelement (7) mit zu den Farben der Diagramme (15, 50, 51, 60, 61, 70, 71, 72, 90, 91) zumindest ähnlichen Farben beleuchtbar und/oder hinterleuchtbar ist,
und **dass** eine Verschiebung eines Vorschaudiagramms (11, 12, 13, 14) an den Rand (30, 31, 32, 33, 67, 68, 69, 691) eines bereits dargestellten ersten Diagramms (15, 50, 51, 60, 61, 70, 71, 72, 90, 91) eine Verkleinerung des ersten Diagramms (15, 50, 51, 60, 61, 70, 71, 72, 90, 91) und eine Darstellung des dem Vorschaudiagramm (11, 12, 13, 14) entsprechenden zweiten Diagramms (15, 50, 51, 60, 61, 70, 71, 72, 90, 91) auf der durch die Verkleinerung frei gewordenen Fläche bewirkt.

2. Messgerät nach Anspruch 1,
**dadurch gekennzeichnet,**
**dass** die Verarbeitungseinrichtung (4) mehrere Diagramme (15, 50, 51, 60, 61, 70, 71, 72, 90, 91) aus dem Messsignal (20, 40, 54, 55, 64, 65, 79, 80, 81, 94) des zumindest einen Messkanals ableitet.

3. Messgerät nach Anspruch 1 oder 2,
**dadurch gekennzeichnet,**
**dass** die Verarbeitungseinrichtung (4) mehrere Messsignale (20, 40, 54, 55, 64, 65, 79, 80, 81, 94) mehrerer Messkanäle misst.

4. Messgerät nach Anspruch 3,
**dadurch gekennzeichnet,**
**dass** die Verarbeitungseinrichtung (4) ein Messsignal (20, 40, 54, 55, 64, 65, 79, 80, 81, 94) aus den Messsignalen (20, 40, 54, 55, 64, 65, 79, 80, 81, 94) mehrerer Messkanäle ableitet.

5. Messgerät nach einem der Ansprüche 1 bis 4,
**dadurch gekennzeichnet,**
**dass** die Vorschaudiagramme (11, 12, 13, 14) bei Bedarf ausgeblendet werden.

6. Messgerät nach einem der Ansprüche 1 bis 5,
**dadurch gekennzeichnet,**
**dass** die Vorschaudiagramme (11, 12, 13, 14) vereinfachte Darstellungen der Diagramme (15, 50, 51, 60, 61, 70, 71, 72, 90, 91) sind, und
**dass** die Vorschaudiagramme (11, 12, 13, 14) Echtzeit-Abbilder der Diagramme (15, 50, 51, 60, 61, 70, 71, 72, 90, 91) sind.

7. Messgerät nach einem der Ansprüche 1 bis 6,
**dadurch gekennzeichnet,**
**dass** die Auswahl der darzustellenden Diagramme (15, 50, 51, 60, 61, 70, 71, 72, 90, 91) durch Auswahl der entsprechenden Vorschaudiagramme (11, 12, 13, 14) erfolgt, und
**dass** eine erneute Auswahl eines Vorschaudiagramms (11, 12, 13, 14), bei bereits erfolgender Darstellung des zugehörigen Diagramms (15, 50, 51, 60, 61, 70, 71, 72, 90, 91) eine Entfernung des zugehörigen Diagramms (15, 50, 51, 60, 61, 70, 71, 72, 90, 91) von der Anzeigeeinrichtung (2) auslöst.

8. Messgerät nach einem der Ansprüche 1 bis 7,
**dadurch gekennzeichnet,**
**dass** die Anzeigeeinrichtung (2) ein berührungsempfindlicher Bildschirm ist, und
**dass** die Auswahl und Positionierung der Vorschaudiagramme (11, 12, 13, 14) auf der Anzeigeeinrichtung (2) durch Berührung und Verschiebung der Vorschaudiagramme (11, 12, 13, 14) erfolgt.

9. Messgerät nach Anspruch 8,
**dadurch gekennzeichnet,**
**dass** das Messgerät (1) über ein Zeigeinstrument (Mouse) (5) verfügt, und
**dass** die Auswahl und Positionierung der Vorschaudiagramme (11, 12, 13, 14) auf der Anzeigeeinrichtung (2) durch Auswahl und Verschiebung der Vorschaudiagramme (11, 12, 13, 14) mit dem Zeigeinstrument (5) erfolgt.

10. Messgerät nach Anspruch 9,
**dadurch gekennzeichnet,**
**dass** die Positionierung der Diagramme (15, 50, 51, 60, 61, 70, 71, 72, 90, 91) durch Auswahl und Verschiebung der Vorschaudiagramme (11, 12, 13, 14) in bestimmte Bereiche (30, 31, 32, 33, 35, 67, 68, 69, 690, 691) der Anzeigeeinrichtung (2) oder in bestimmte Bereiche (30, 31, 32, 33, 35, 67, 68, 69, 690, 691) bereits dargestellter Diagramme (15, 50, 51, 60, 61, 70, 71, 72, 90, 91) erfolgt und
**dass** eine Verschiebung eines Vorschaudiagramms (11, 12, 13, 14) auf der Anzeigeeinrichtung (2) ohne vorherige Darstellung eines Diagramms (15, 50, 51, 60, 61, 70, 71, 72, 90, 91) die Darstellung eines dem Vorschaudiagramm (11, 12, 13, 14) entsprechenden Diagramms (15, 50, 51, 60, 61, 70, 71, 72, 90, 91) auf weitgehend der gesamten Anzeigeeinrichtung (2) bewirkt.

11. Messgerät nach Anspruch 10,
**dadurch gekennzeichnet,**
**dass** eine Verschiebung eines Vorschaudiagramms (11, 12, 13, 14) in die Mitte (35, 690) eines bereits dargestellten ersten Diagramms (15, 50, 51, 60, 61, 70, 71, 72, 90, 91) eine Überlagerung des ersten Diagramms (15, 50, 51, 60, 61, 70, 71, 72, 90, 91) und des dem Vorschaudiagramm (11, 12, 13, 14) entsprechenden zweiten Diagramms (15, 50, 51, 60, 61, 70, 71, 72, 90, 91) bewirkt.

12. Messgerät nach einem der Ansprüche 1 bis 11,
**dadurch gekennzeichnet,**
**dass** die Verkleinerung dergestalt erfolgt, dass die Darstellung des zweiten Diagramms (15, 50, 51, 60, 61, 70, 71, 72, 90, 91) auf der Seite des Randes (30, 31, 32, 33, 67, 68, 69, 691) des ersten Diagramms (15, 50, 51, 60, 61, 70, 71, 72, 90, 91) erfolgt, an welchen das Vorschaudiagramm (11, 12, 13, 14) verschoben wurde.

13. Messgerät nach einem der Ansprüche 1 bis 12,
**dadurch gekennzeichnet,**
**dass** bei Darstellung eines Diagramms (15, 50, 51, 60, 61, 70, 71, 72, 90, 91) das dem Diagramm (15, 50, 51, 60, 61, 70, 71, 72, 90, 91) entsprechende Vorschaudiagramm (11, 12, 13, 14) ausgeblendet oder durch Konfigurationsparameter ersetzt ist.

14. Messgerät nach einem der Ansprüche 1 bis 13,
**dadurch gekennzeichnet,**
**dass** die Anzeigeeinrichtung (2) die Vorschaudiagramme (11, 12, 13, 14) zu einem von der Verarbeitungseinrichtung (4) festgelegten beliebigem Grad transparent darstellt, und dass die Anzeigeeinrichtung (2) die Vorschaudiagramme (11, 12, 13, 14) den Diagrammen (15, 50, 51, 60, 61, 70, 71, 72, 90, 91) überlagert darstellt.

15. Messgerät nach einem der Ansprüche 1 bis 14,
**dadurch gekennzeichnet,**
**dass** die Bedieneinheit (6) des Messgeräts (1) über mehrere Bedienelemente (7) verfügt,
**dass** die mehreren Bedienelemente (7) mit, den Farben der Diagramme (15, 50, 51, 60, 61, 70, 71, 72, 90, 91) zumindest ähnlichen Farben beleuchtbar und/oder hinterleuchtbar sind,
**dass** genau ein von dem Messgerät (1) dargestelltes Diagramm (15, 50, 51, 60, 61, 70, 71, 72, 90, 91) ein aktives Diagramm (15, 50, 51, 60, 61, 70, 71, 72, 90, 91) ist,
**dass** das zuletzt platzierte oder veränderte Diagramm (15, 50, 51, 60, 61, 70, 71, 72, 90, 91) das aktive Diagramm (15, 50, 51, 60, 61, 70, 71, 72, 90, 91) ist, und
**dass** zumindest ein Bedienelement (7) mit einer der Farbe des aktiven Diagramm (15, 50, 51, 60, 61, 70, 71, 72, 90, 91) zumindest ähnlichen Farbe beleuchtet oder hinterleuchtet ist.

16. Messgerät nach Anspruch 15,
**dadurch gekennzeichnet,**
**dass** das aktive Diagramm (15, 50, 51, 60, 61, 70, 71, 72, 90, 91) durch Auswahl eines Diagramms (15, 50, 51, 60, 61, 70, 71, 72, 90, 91) auf der Anzeigeeinrichtung (2) gewechselt wird, und
**dass** mit dem Wechsel des aktiven Diagramms (15, 50, 51, 60, 61, 70, 71, 72, 90, 91) die Beleuchtung oder Hinterleuchtung zumindest eines Bedienelements (7) auf eine der Farbe des aktiven Diagramms (15, 50, 51, 60, 61, 70, 71, 72, 90, 91) ähnliche Farbe wechselt.

17. Messverfahren mit einem Messgerät (1),
wobei das Messgerät (1) über eine Anzeigeeinrichtung (2), eine Verarbeitungseinrichtung (4) und zumindest einem Messkanal verfügt,
wobei mittels der Verarbeitungseinrichtung (4) Messsignale (20, 40, 54, 55, 64, 65, 79, 80, 81, 94) des zumindest einen Messkanals gemessen werden,
wobei mittels der Anzeigeeinrichtung (2) das Messsignal (20, 40, 54, 55, 64, 65, 79, 80, 81, 94) des zumindest einen Messkanals als Diagramm (15, 50, 51, 60, 61, 70, 71, 72, 90, 91) darstellt wird,
wobei mehrere Diagramme (50, 51, 60, 61, 70, 71, 72, 90, 91) gleichzeitig dargestellt werden können,
wobei die Anzeigeeinrichtung (2) zusätzlich Vorschaudiagramme (11, 12, 13, 14) darstellt,
wobei die Vorschaudiagramme (11, 12, 13, 14) verkleinerte Darstellungen der Diagramme (15, 50, 51, 60, 61, 70, 71, 72, 90, 91) sind,
wobei das Messgerät (1) weiterhin über eine Bedieneinheit (6) mit zumindest einem Bedienelement (7) verfügt,
wobei die mehreren Diagramme (50, 51, 60, 61, 70, 71, 72, 90, 91) überlagert und/oder nebeneinander und/oder untereinander dargestellt werden,
wobei die mehreren Diagramme (50, 51, 60, 61, 70, 71, 72, 90, 91) an unterschiedlichen Positionen der Anzeigeeinrichtung (2) dargestellt werden, und wobei die Diagramme (15, 50, 51, 60, 61, 70 71, 72, 90, 91) auf der Anzeigeeinrichtung (2) durch Positionierung der Vorschaudiagramme (11, 12, 13, 14) in bestimmten Bereichen (30, 31, 32, 33, 35, 67, 68, 69, 690, 691) der Anzeigeeinrichtung (2) angeordnet werden,
**dadurch gekennzeichnet, dass** jedes dargestellte Diagramm (15, 50, 51, 60, 61, 70, 71, 72, 90, 91) in einer, von den Farben der Darstellungen der übrigen Diagramme (15, 50, 51, 60, 61, 70, 71, 72, 90, 91) unterscheidbaren Farbe dargestellt wird,
dass das zumindest eine Bedienelement (7) mit zu den Farben der Diagramme (15, 50, 51, 60, 61, 70, 71, 72, 90, 91) zumindest ähnlichen Farben beleuchtet und/oder hinterleuchtet werden,
und dass eine Verschiebung eines Vorschaudiagramms (11, 12, 13, 14) an den Rand (30, 31, 32, 33, 67, 68, 69, 691) eines bereits dargestellten ersten Diagramms (15, 50, 51, 60, 61, 70, 71, 72, 90, 91) eine Verkleinerung des ersten Diagramms (15, 50, 51, 60, 61, 70, 71, 72, 90, 91) und
eine Darstellung des dem Vorschaudiagramm (11, 12, 13, 14) entsprechenden zweiten Diagramms (15, 50, 51, 60, 61, 70, 71, 72, 90, 91) auf der durch die Verkleinerung frei gewordenen Fläche bewirkt.

18. Messverfahren nach Anspruch 17,
**dadurch gekennzeichnet,**
**dass** mehrere Diagramme (15, 50, 51, 60, 61, 70, 71, 72, 90, 91) aus dem Messsignal (20, 40, 54, 55, 64, 65, 79, 80, 81, 94) des zumindest einen Messkanals abgeleitet werden können.

19. Messverfahren nach Anspruch 17 oder 18,
**dadurch gekennzeichnet,**
**dass** mehrere Messsignale (20, 40, 54, 55, 64, 65, 79, 80, 81, 94) mehrerer Messkanäle gemessen werden können.

20. Messverfahren nach Anspruch 19,
**dadurch gekennzeichnet,**
**dass** ein Messsignal (20, 40, 54, 55, 64, 65, 79, 80, 81, 94) gleichzeitig aus den Messsignalen (20, 40, 54, 55, 64, 65, 79, 80, 81, 94) mehrerer Messkanäle abgeleitet werden kann.

21. Messverfahren nach einem der Ansprüche 17 bis 20,
**dadurch gekennzeichnet,**
**dass** die Vorschaudiagramme (11, 12, 13, 14) bei Bedarf ausgeblendet werden.

22. Messverfahren nach Anspruch 21,
**dadurch gekennzeichnet,**
**dass** die Vorschaudiagramme (11, 12, 13, 14) vereinfachte Darstellungen der Diagramme (15, 50, 51, 60, 61, 70, 71, 72, 90, 91) sind, und
**dass** die Vorschaudiagramme (11, 12, 13, 14) Echtzeit-Abbilder der Diagramme (15, 50, 51, 60, 61, 70, 71, 72, 90, 91) sind.

23. Messverfahren nach Anspruch 21 oder 22,
**dadurch gekennzeichnet,**
**dass** die darzustellenden Diagramme (15, 50, 51, 60, 61, 70, 71, 72, 90, 91) durch Auswahl der entsprechenden Vorschaudiagramme (11, 12, 13, 14) ausgewählt werden, und dass bei erneuter Auswahl eines Vorschaudiagramms (11, 12, 13, 14), bei bereits erfolgender Darstellung des zugehörigen Diagramms (15, 50, 51, 60, 61, 70, 71, 72, 90, 91) das zugehörige Diagramm (15, 50, 51, 60, 61, 70, 71, 72, 90, 91) von der Anzeigeeinrichtung (2) entfernt wird.

24. Messverfahren nach einem der Ansprüche 17 bis 23,
**dadurch gekennzeichnet,**
**dass** die Anzeigeeinrichtung (2) ein berührungsempfindlicher Bildschirm ist, und
**dass** die Vorschaudiagramme (11, 12, 13, 14) durch Berührung und Verschiebung ausgewählt und auf der Anzeigeeinrichtung (2) positioniert werden.

25. Messverfahren nach einem der Ansprüche 17 bis 24,
**dadurch gekennzeichnet,**
**dass** das Messgerät über ein Zeigeinstrument (Mouse) (5) verfügt, und
**dass** die Vorschaudiagramme (11, 12, 13, 14) durch Auswahl und Verschiebung mit dem Zeigeinstrument (5) auf der Anzeigeeinrichtung (2) positioniert werden.

26. Messverfahren nach Anspruch 25,
**dadurch gekennzeichnet,**
**dass** die Diagramme (15, 50, 51, 60, 61, 70, 71, 72, 90, 91) durch Auswahl und Verschiebung der Vorschaudiagramme (11, 12, 13, 14) in bestimmte Bereiche (30, 31, 32, 33, 35, 67, 68, 69, 690, 691) der Anzeigeeinrichtung (2) oder in bestimmte Bereiche (30, 31, 32, 33, 35, 67, 68, 69, 690, 691) bereits dargestellter Diagramme (15, 50, 51, 60, 61, 70, 71, 72, 90, 91) positioniert werden und
**dass** eine Verschiebung eines Vorschaudiagramms (11, 12, 13, 14) auf der Anzeigeeinrichtung (2), ohne vorherige Darstellung eines Diagramms (15, 50, 51, 60, 61, 70, 71, 72, 90, 91), die Darstellung eines dem Vorschaudiagramm (11, 12, 13, 14) entsprechenden Diagramms (15, 50, 51, 60, 61, 70, 71, 72, 90, 91) auf weitgehend der gesamten Anzeigeeinrichtung (2) bewirkt.

27. Messverfahren nach Anspruch 26,
**dadurch gekennzeichnet,**
**dass** eine Verschiebung eines Vorschaudiagramms (11, 12, 13, 14) in die Mitte (35, 690) eines bereits dargestellten ersten Diagramms (15, 50, 51, 60, 61, 70, 71, 72, 90, 91) eine Überlagerung des ersten Diagramms (15, 50, 51, 60, 61, 70, 71, 72, 90, 91) und des dem Vorschaudiagramm (11, 12, 13, 14) entsprechenden zweiten Diagramms (15, 50, 51, 60, 61, 70, 71, 72, 90, 91) bewirkt.

28. Messverfahren nach Anspruch 26 oder 27,
**dadurch gekennzeichnet,**
**dass** die Verkleinerung dergestalt erfolgt, dass die Darstellung des zweiten Diagramms (15, 50, 51, 60, 61, 70, 71, 72, 90, 91) auf der Seite des Randes (30, 31, 32, 33, 67, 68, 69, 691) des ersten Diagramms (15, 50, 51, 60, 61, 70, 71, 72, 90, 91) erfolgt, an welchen das Vorschaudiagramm (11, 12, 13, 14) verschoben wurde.

29. Messverfahren nach einem der Ansprüche 17 bis 28,
**dadurch gekennzeichnet,**
**dass** bei Darstellung eines Diagramms (15, 50, 51, 60, 61, 70, 71, 72, 90, 91) das dem Diagramm (15, 50, 51, 60, 61, 70, 71, 72, 90, 91) entsprechende Vorschaudiagramm (11, 12, 13, 14) ausgeblendet oder durch Konfigurationsparameter ersetzt wird.

30. Messverfahren nach einem der Ansprüche 17 bis 29,
**dadurch gekennzeichnet,**
**dass** die Vorschaudiagramme (11, 12, 13, 14) transparent dargestellt werden, und
**dass** die Vorschaudiagramme (11, 12, 13, 14) den Diagrammen (15, 50, 51, 60, 61, 70, 71, 72, 90, 91) überlagert dargestellt werden.

31. Messverfahren nach einem der Ansprüche 17 bis 30,
**dadurch gekennzeichnet,**
**dass** die Bedieneinheit (6) des Messgeräts (1) über mehrere Bedienelemente (7) verfügt,
**dass** die mehreren Bedienelemente (7) mit, den Farben der Diagramme (15, 50, 51, 60, 61, 70, 71, 72, 90, 91) zumindest ähnlichen Farben beleuchtet und/oder hinterleuchtet werden können,
**dass** genau ein von dem Messgerät (1) dargestelltes Diagramm (15, 50, 51, 60, 61, 70, 71, 72, 90, 91) ein aktives Diagramm (15, 50, 51, 60, 61, 70, 71, 72, 90, 91) ist,
**dass** das zuletzt platzierte oder veränderte Diagramm (15, 50, 51, 60, 61, 70, 71, 72, 90, 91) das aktive Diagramm (15, 50, 51, 60, 61, 70, 71, 72, 90, 91) ist, und
**dass** zumindest ein Bedienelement (7) mit einer der Farbe des aktiven Diagramms (15, 50, 51, 60, 61, 70, 71, 72, 90, 91) zumindest ähnlichen Farbe beleuchtet oder hinterleuchtet wird.

32. Messverfahren nach Anspruch 31,
**dadurch gekennzeichnet,**
**dass** das aktive Diagramm (15, 50, 51, 60, 61, 70, 71, 72, 90, 91) durch Auswahl eines Diagramms (15, 50, 51, 60, 61, 70, 71, 72, 90, 91) auf der Anzeigeeinrichtung (2) gewechselt wird, und
**dass** mit dem Wechsel des aktiven Diagramms (15, 50, 51, 60, 61, 70, 71, 72, 90, 91) die Beleuchtung oder Hinterleuchtung zumindest eines Bedienelements (7) auf eine der Farbe des aktiven Diagramms (15, 50, 51, 60, 61, 70, 71, 72, 90, 91) ähnliche Farbe wechselt.

## Claims

1. Measuring apparatus (1) with a display unit (2), a processing unit (4) and at least one measurement channel, wherein the processing unit (4) measures the measurement signal (20, 40, 54, 55, 64, 65, 79, 80, 81, 94) of the at least one measurement channel,
wherein the display unit (2) displays the measurement signal (20, 40, 54, 55, 64, 65, 79, 80, 81, 94) of the at least one measurement channel as a graph (15, 50, 51, 60, 61, 70, 71, 72, 90, 91),
wherein a plurality of graphs (50, 51, 60, 61, 70, 71, 72, 90, 91) can be displayed simultaneously,
wherein in addition preview graphs (11, 12, 13, 14) can be displayed with the display unit (2),
wherein the preview graphs (11, 12, 13, 14) are reduced size displays of the graphs (15, 50, 51, 60, 61, 70, 71, 72, 90, 91),
wherein the measuring apparatus (1) also has a control unit (6) with at least one control element (7),
wherein the plurality of graphs (50, 51, 60, 61, 70, 71, 72, 90, 91) can be displayed overlaid and/or side by side and/or one below another,
wherein the plurality of graphs (50, 51, 60, 61, 70, 71, 72, 90, 91) can be displayed in different positions of the display unit (2),
and wherein the arrangement of the graphs (15, 50, 51, 60, 61, 70, 71, 72, 90, 91) on the display unit (2) is carried out by positioning of the preview graphs (11, 12, 13, 14) in specific areas (30, 31, 32, 33, 35, 67, 68, 69, 690, 691) of the display unit (2),
**characterised in that**
each displayed graph (15, 50, 51, 60, 61, 70, 71, 72, 90, 91) is displayed in a colour which can be distinguished from the colours of the displays of the remaining graphs (15, 50, 51, 60, 61, 70, 71, 72, 90, 91),
**in that** the at least one control element (7) can be illuminated and/or backlit with colours which are at least similar to the colours of the graphs (15, 50, 51, 60, 61, 70, 71, 72, 90, 91),
and **in that** movement of a preview graph (11, 12, 13, 14) to the edge (30, 31, 32, 33, 67, 68, 69, 691) of an already displayed first graph (15, 50, 51, 60, 61, 70, 71, 72, 90, 91) causes a reduction in the size of the first graph (15, 50, 51, 60, 61, 70, 71, 72, 90, 91) and the display of the second graph (15, 50, 51, 60, 61, 70, 71, 72, 90, 91) corresponding to the preview graph (11, 12, 13, 14) in the area left free by the reduction in size.

2. Measuring apparatus according to claim 1,
**characterised in that**
the processing unit (4) derives a plurality of graphs (15, 50, 51, 60, 61, 70, 71, 72, 90, 91) from the measurement signal (20, 40, 54, 55, 64, 65, 79, 80, 81, 94) of the at least one measurement channel.

3. Measuring apparatus according to claim 1 or 2,
**characterised in that**
the processing unit (4) measures a plurality of measurement signals (20, 40, 54, 55, 64, 65, 79, 80, 81, 94) of a plurality of measurement channels.

4. Measuring apparatus according to claim 3,
**characterised in that**
the processing unit (4) derives a measurement signal (20, 40, 54, 55, 64, 65, 79, 80, 81, 94) from the measurement signals (20, 40, 54, 55, 64, 65, 79, 80, 81, 94) of a plurality of measurement channels.

5. Measuring apparatus according to one of claims 1 to 4,
**characterised in that**
the preview graphs (11, 12, 13, 14) are blanked out if necessary.

6. Measuring apparatus according to one of claims 1 to 5,
**characterised in that**
the preview graphs (11, 12, 13, 14) are simplified displays of the graphs (15, 50, 51, 60, 61, 70, 71, 72, 90, 91), and
**in that** the preview graphs (11, 12, 13, 14) are real-time images of the graphs (15, 50, 51, 60, 61, 70, 71, 72, 90, 91) .

7. Measuring apparatus according to one of claims 1 to 6,
**characterised in that**
the selection of the graphs (15, 50, 51, 60, 61, 70, 71, 72, 90, 91) to be displayed is carried out by selection of the corresponding preview graphs (11, 12, 13, 14), and
**in that** renewed selection of a preview graph (11, 12, 13, 14), when the associated graph (15, 50, 51, 60, 61, 70, 71, 72, 90, 91) is already being displayed leads to the removal of the associated graph (15, 50, 51, 60, 61, 70, 71, 72, 90, 91) from the display unit (2).

8. Measuring apparatus according to one of claims 1 to 7,
**characterised in that**
the display unit (2) is a touch-sensitive screen, and
**in that** the selection and positioning of the preview graphs (11, 12, 13, 14) on the display unit (2) is carried out by touching and moving the preview graphs (11, 12, 13, 14) .

9. Measuring apparatus according to claim 8,
**characterised in that**
the measuring apparatus (1) has a pointing device (mouse) (5), and
**in that** the selection and positioning of the preview graphs (11, 12, 13, 14) on the display unit (2) is carried out by selecting and moving the preview graphs (11, 12, 13, 14) with the pointing device (5).

10. Measuring apparatus according to claim 9,
**characterised in that**
the positioning of the graphs (15, 50, 51, 60, 61, 70, 71, 72, 90, 91) is carried out by selecting and moving the preview graphs (11, 12, 13, 14) into specific areas (30, 31, 32, 33, 35, 67, 68, 69, 690, 691) of the display unit (2) or into specific areas (30, 31, 32, 33, 35, 67, 68, 69, 690, 691) of already displayed graphs (15, 50, 51, 60, 61, 70, 71, 72, 90, 91) and
**in that** movement of a preview graph (11, 12, 13, 14) on the display unit (2) without having previously displayed a graph (15, 50, 51, 60, 61, 70, 71, 72, 90, 91) causes the display of a graph (15, 50, 51, 60, 61, 70, 71, 72, 90, 91) corresponding to the preview graph (11, 12, 13, 14) on largely the entire display unit (2).

11. Measuring apparatus according to claim 10,
**characterised in that**
movement of a preview graph (11, 12, 13, 14) into the middle (35, 690) of an already displayed first graph (15, 50, 51, 60, 61, 70, 71, 72, 90, 91) causes overlaying of the first graph (15, 50, 51, 60, 61, 70, 71, 72, 90, 91) and the second graph (15, 50, 51, 60, 61, 70, 71, 72, 90, 91) corresponding to the preview graph (11, 12, 13, 14).

12. Measuring apparatus according to one of claims 1 to 11,
**characterised in that**
the reduction in size is carried out in such a way that the second graph (15, 50, 51, 60, 61, 70, 71, 72, 90, 91) is displayed on the side of the edge (30, 31, 32, 33, 67, 68, 69, 691) of the first graph (15, 50, 51, 60, 61, 70, 71, 72, 90, 91) to which the preview graph (11, 12, 13, 14) was moved.

13. Measuring apparatus according to one of claims 1 to 12,
**characterised in that**
when a graph (15, 50, 51, 60, 61, 70, 71, 72, 90, 91) is displayed, the preview graph (11, 12, 13, 14) corresponding to the graph (15, 50, 51, 60, 61, 70, 71, 72, 90, 91) is blanked out or replaced by configuration parameters.

14. Measuring apparatus according to one of claims 1 to 13,
**characterised in that**
the display unit (2) displays the preview graphs (11, 12, 13, 14) transparently to an arbitrary degree set by the processing unit (4), and
**in that** the display unit (2) displays the preview graphs (11, 12, 13, 14) overlaying the graphs (15, 50, 51, 60, 61, 70, 71, 72, 90, 91).

15. Measuring apparatus according to one of claims 1 to 14,
**characterised in that**
the control unit (6) of the measuring apparatus (1) has a plurality of control elements (7),
**in that** the plurality of control elements (7) can be illuminated or backlit with colours which are at least similar to the colours of the graphs (15, 50, 51, 60, 61, 70, 71, 72, 90, 91),
**in that** just one graph (15, 50, 51, 60, 61, 70, 71, 72, 90, 91) displayed by the measuring apparatus (1) is an active graph (15, 50, 51, 60, 61, 70, 71, 72, 90, 91),
**in that** the last placed or changed graph (15, 50, 51, 60, 61, 70, 71, 72, 90, 91) is the active graph (15, 50, 51, 60, 61, 70, 71, 72, 90, 91), and
**in that** at least one control element (7) is illuminated or backlit with a colour which is at least similar to the colour of the active graph (15, 50, 51, 60, 61, 70, 71, 72, 90, 91).

16. Measuring apparatus according to claim 15, **characterised in that**
the active graph (15, 50, 51, 60, 61, 70, 71, 72, 90, 91) is changed by selecting a graph (15, 50, 51, 60, 61, 70, 71, 72, 90, 91) on the display unit (2), and
**in that** when the active graph (15, 50, 51, 60, 61, 70, 71, 72, 90, 91) is changed, the illumination or backlighting of at least one control element (7) changes to a colour similar to the colour of the active graph (15, 50, 51, 60, 61, 70, 71, 72, 90, 91).

17. Measuring method with a measuring apparatus (1), wherein the measuring apparatus (1) has a display unit (2), a processing unit (4) and at least one measurement channel,
wherein measurement signals (20, 40, 54, 55, 64, 65, 79, 80, 81, 94) of the at least one measurement channel are measured by means of the processing unit (4),
wherein the measurement signal (20, 40, 54, 55, 64, 65, 79, 80, 81, 94) of the at least one measurement channel is displayed as a graph (15, 50, 51, 60, 61, 70, 71, 72, 90, 91) by means of the display unit (2),
wherein a plurality of graphs (50, 51, 60, 61, 70, 71, 72, 90, 91) can be displayed simultaneously,
wherein in addition the display unit (2) displays preview graphs (11, 12, 13, 14),
wherein the preview graphs (11, 12, 13, 14) are reduced size displays of the graphs (15, 50, 51, 60, 61, 70, 71, 72, 90, 91),
wherein the measuring apparatus (1) also has a control unit (6) with at least one control element (7),
wherein the plurality of graphs (50, 51, 60, 61, 70, 71, 72, 90, 91) are displayed overlaid and/or side by side and/or one below another,
wherein the plurality of graphs (50, 51, 60, 61, 70, 71, 72, 90, 91) are displayed in different positions of the display unit (2),
and wherein the graphs (15, 50, 51, 60, 61, 70, 71, 72, 90, 91) are arranged on the display unit (2) by positioning the preview graphs (11, 12, 13, 14) in specific areas (30, 31, 32, 33, 35, 67, 68, 69, 690, 691) of the display unit (2),
**characterized in that**
each displayed graph (15, 50, 51, 60, 61, 70, 71, 72, 90, 91) is displayed in a colour which can be distinguished from the colours of the displays of the remaining graphs (15, 50, 51, 60, 61, 70, 71, 72, 90, 91),
**in that** the at least one control element (7) is illuminated and/or backlit with colours which are at least similar to the colours of the graphs (15, 50, 51, 60, 61, 70, 71, 72, 90, 91),
and **in that** movement of a preview graph (11, 12, 13, 14) to the edge (30, 31, 32, 33, 67, 68, 69, 691) of an already displayed first graph (15, 50, 51, 60, 61, 70, 71, 72, 90, 91) causes a reduction in the size of the first graph (15, 50, 51, 60, 61, 70, 71, 72, 90, 91) and the display of the second graph (15, 50, 51, 60, 61, 70, 71, 72, 90, 91) corresponding to the preview graph (11, 12, 13, 14) in the area left free by the reduction in size.

18. Measuring method according to claim 17,
**characterised in that**
a plurality of graphs (15, 50, 51, 60, 61, 70, 71, 72, 90, 91) can be derived from the measurement signal (20, 40, 54, 55, 64, 65, 79, 80, 81, 94) of the at least one measurement channel.

19. Measuring method according to claim 17 or 18,
**characterised in that**
a plurality of measurement signals (20, 40, 54, 55, 64, 65, 79, 80, 81, 94) of a plurality of measurement channels can be measured.

20. Measuring method according to claim 19,
**characterised in that**
a measurement signal (20, 40, 54, 55, 64, 65, 79, 80, 81, 94) can be derived from the measurement signals (20, 40, 54, 55, 64, 65, 79, 80, 81, 94) of a plurality of measurement channels simultaneously.

21. Measuring method according to one of claims 17 to 20,
**characterised in that**
the preview graphs (11, 12, 13, 14) can be blanked out if necessary.

22. Measuring method according to claim 21,
**characterised in that**
the preview graphs (11, 12, 13, 14) are simplified displays of the graphs (15, 50, 51, 60, 61, 70, 71, 72, 90, 91), and
**in that** the preview graphs (11, 12, 13, 14) are real-time images of the graphs (15, 50, 51, 60, 61, 70, 71, 72, 90, 91) .

23. Measuring method according to claim 21 or 22,
**characterised in that**
the graphs (15, 50, 51, 60, 61, 70, 71, 72, 90, 91) to be displayed are selected by selecting the corresponding preview graphs (11, 12, 13, 14), and
**in that** if a preview graph (11, 12, 13, 14) is selected again when the associated graph (15, 50, 51, 60, 61, 70, 71, 72, 90, 91) is already being displayed, the associated graph (15, 50, 51, 60, 61, 70, 71, 72, 90, 91) is removed from the display unit (2).

24. Measuring method according to one of claims 17 to 23,
**characterised in that**
the display unit (2) is a touch-sensitive screen, and
**in that** the preview graphs (11, 12, 13, 14) are selected and positioned on the display unit (2) by touching and moving.

25. Measuring method according to one of claims 17 to 24,
**characterised in that**
the measuring apparatus has a pointing device (mouse) (5), and
**in that** the preview graphs (11, 12, 13, 14) are positioned on the display unit (2) by selecting and moving with the pointing device (5).

26. Measuring method according to claim 25,
**characterised in that**
the graphs (15, 50, 51, 60, 61, 70, 71, 72, 90, 91) are positioned by selecting and moving the preview graphs (11, 12, 13, 14) into specific areas (30, 31, 32, 33, 35, 67, 68, 69, 690, 691) of the display unit (2) or into specific areas (30, 31, 32, 33, 35, 67, 68, 69, 690, 691) of already displayed graphs (15, 50, 51, 60, 61, 70, 71, 72, 90, 91) and
**in that** movement of a preview graph (11, 12, 13, 14) on the display unit (2) without having previously displayed a graph (15, 50, 51, 60, 61, 70, 71, 72, 90, 91), causes the display of a graph (15, 50, 51, 60, 61, 70, 71, 72, 90, 91) corresponding to the preview graph (11, 12, 13, 14) on largely the entire display unit (2).

27. Measuring method according to claim 26,
**characterised in that**
movement of a preview graph (11, 12, 13, 14) into the middle (35, 690) of an already displayed first graph (15, 50, 51, 60, 61, 70, 71, 72, 90, 91) causes overlaying of the first graph (15, 50, 51, 60, 61, 70, 71, 72, 90, 91) and the second graph (15, 50, 51, 60, 61, 70, 71, 72, 90, 91) corresponding to the preview graph (11, 12, 13, 14).

28. Measuring method according to claim 26 or 27,
**characterised in that**
the reduction in size is carried out in such a way that the second graph (15, 50, 51, 60, 61, 70, 71, 72, 90, 91) is displayed on the side of the edge (30, 31, 32, 33, 67, 68, 69, 691) of the first graph (15, 50, 51, 60, 61, 70, 71, 72, 90, 91) to which the preview graph (11, 12, 13, 14) was moved.

29. Measuring method according to one of claims 17 to 28,
**characterised in that**
when a graph (15, 50, 51, 60, 61, 70, 71, 72, 90, 91) is displayed, the preview graph (11, 12, 13, 14) corresponding to the graph (15, 50, 51, 60, 61, 70, 71, 72, 90, 91) is blanked out or replaced by configuration parameters.

30. Measuring method according to one of claims 17 to 29,
**characterised in that**
the preview graphs (11, 12, 13, 14) are displayed transparently, and
**in that** the preview graphs (11, 12, 13, 14) are displayed overlaying the graphs (15, 50, 51, 60, 61, 70, 71, 72, 90, 91) .

31. Measuring method according to one of claims 17 to 30,
**characterised in that**
the control unit (6) of the measuring apparatus (1) has a plurality of control elements (7),
**in that** the plurality of control elements (7) can be illuminated and/or backlit with colours which are at least similar to the colours of the graphs (15, 50, 51, 60, 61, 70, 71, 72, 90, 91),
**in that** just one graph (15, 50, 51, 60, 61, 70, 71, 72, 90, 91) displayed by the measuring apparatus (1) is an active graph (15, 50, 51, 60, 61, 70, 71, 72, 90, 91),
**in that** the last placed or changed graph (15, 50, 51, 60, 61, 70, 71, 72, 90, 91) is the active graph (15, 50, 51, 60, 61, 70, 71, 72, 90, 91), and
**in that** at least one control element (7) is illuminated or backlit with a colour which is at least similar to the colour of the active graph (15, 50, 51, 60, 61, 70, 71, 72, 90, 91).

32. Measuring method according to claim 31,
**characterised in that**
the active graph (15, 50, 51, 60, 61, 70, 71, 72, 90, 91) is changed by selecting a graph (15, 50, 51, 60, 61, 70, 71, 72, 90, 91) on the display unit (2), and
**in that** when the active graph (15, 50, 51, 60, 61, 70, 71, 72, 90, 91) is changed, the illumination or backlighting of at least one control element (7) changes to a colour which is similar to the colour of the active graph (15, 50, 51, 60, 61, 70, 71, 72, 90, 91).

## Revendications

1. Appareil de mesure (1) avec un dispositif d'affichage (2), un dispositif de traitement (4) et au moins un canal de mesure,
dans lequel le dispositif de traitement (4) mesure le signal de mesure (20, 40, 54, 55, 64, 65, 79, 80, 81, 94) dudit au moins un canal de mesure,
dans lequel le dispositif d'affichage (2) représente le signal de mesure (20, 40, 54, 55, 64, 65, 79, 80, 81, 94) dudit au moins un canal de mesure sous forme de diagramme (15, 50, 51, 60, 61, 70, 71, 72, 90, 91),
dans lequel plusieurs diagrammes (50, 51, 60, 61, 70, 71, 72, 90, 91) peuvent être représentés simultanément,
dans lequel des diagrammes de prévisualisation (11, 12, 13, 14) peuvent en outre être représentés par le dispositif d'affichage (2),
dans lequel les diagrammes de prévisualisation (11, 12, 13, 14) sont des représentations en réduction des diagrammes (15, 50, 51, 60, 61, 70, 71, 72, 90, 91),
dans lequel l'appareil de mesure (1) est en outre doté d'une unité de commande (6) ayant au moins un élément de commande (7), et
dans lequel les plusieurs diagrammes (50, 51, 60, 61, 70, 71, 72, 90, 91) peuvent être représentés superposés et/ou juxtaposés et/ou l'un au-dessous de l'autre,
dans lequel les plusieurs diagrammes (50, 51, 60, 61, 70, 71, 72, 90, 91) peuvent être représentés à des emplacements différents du dispositif d'affichage (2),
et dans lequel l'agencement des diagrammes (15, 50, 51, 60, 61, 70, 71, 72, 90, 91) sur le dispositif d'affichage (2) est effectué par positionnement des diagrammes de prévisualisation (11, 12, 13, 14) dans des zones (30, 31, 32, 33, 35, 67, 68, 69, 690, 691) définies du dispositif d'affichage (2),
**caractérisé**
**en ce que** chaque diagramme (15, 50, 51, 60, 61, 70, 71, 72, 90, 91) représenté est représenté dans une couleur différenciable des couleurs des représentations des autres diagrammes (15, 50, 51, 60, 61, 70, 71, 72, 90, 91),
**en ce que** ledit au moins un élément de commande (7) peut être éclairé et/ou rétro-éclairé avec des couleurs au moins similaires aux couleurs des diagrammes (15, 50, 51, 60, 61, 70, 71, 72, 90, 91),
et **en ce qu'**un déplacement d'un diagramme de prévisualisation (11, 12, 13, 14) sur le bord (30, 31, 32, 33, 67, 68, 69, 691) d'un premier diagramme (15, 50, 51, 60, 61, 70, 71, 72, 90, 91) déjà représenté entraîne une réduction du premier diagramme (15, 50, 51, 60, 61, 70, 71, 72, 90, 91) et une représentation du deuxième diagramme (15, 50, 51, 60, 61, 70, 71, 72, 90, 91) correspondant au diagramme de prévisualisation (11, 12, 13, 14) sur la surface libérée par la réduction.

2. Appareil de mesure selon la revendication 1,
**caractérisé**
**en ce que** le dispositif de traitement (4) déduit plusieurs diagrammes (15, 50, 51, 60, 61, 70, 71, 72, 90, 91) du signal de mesure (20, 40, 54, 55, 64, 65, 79, 80, 81, 94) dudit au moins un canal de mesure.

3. Appareil de mesure selon la revendication 1 ou 2,
**caractérisé**
**en ce que** le dispositif de traitement (4) mesure plusieurs signaux de mesure (20, 40, 54, 55, 64, 65, 79, 80, 81, 94) de plusieurs canaux de mesure.

4. Appareil de mesure selon la revendication 3,
**caractérisé**
**en ce que** le dispositif de traitement (4) déduit un signal de mesure (20, 40, 54, 55, 64, 65, 79, 80, 81, 94) des signaux de mesure (20, 40, 54, 55, 64, 65, 79, 80, 81, 94) de plusieurs canaux de mesure.

5. Appareil de mesure selon l'une des revendications 1 à 4,
**caractérisé**
**en ce que** les diagrammes de prévisualisation (11, 12, 13, 14) sont masqués si besoin.

6. Appareil de mesure selon l'une des revendications 1 à 5,
**caractérisé**
**en ce que** les diagrammes de prévisualisation (11, 12, 13, 14) sont des représentations simplifiées des diagrammes (15, 50, 51, 60, 61, 70, 71, 72, 90, 91), et
**en ce que** les diagrammes de prévisualisation (11, 12, 13, 14) sont des images en temps réel des diagrammes (15, 50, 51, 60, 61, 70, 71, 72, 90, 91).

7. Appareil de mesure selon l'une des revendications 1 à 6,
**caractérisé**
**en ce que** la sélection des diagrammes (15, 50, 51, 60, 61, 70, 71, 72, 90, 91) à représenter est effectuée par sélection des diagrammes de prévisualisation (11, 12, 13, 14) correspondants, et
**en ce qu'**une nouvelle sélection d'un diagramme de prévisualisation (11, 12, 13, 14) provoque, en cas de représentation en cours du diagramme (15, 50, 51, 60, 61, 70, 71, 72, 90, 91) correspondant, une suppression du diagramme (15, 50, 51, 60, 61, 70, 71, 72, 90, 91) correspondant du dispositif d'affichage (2).

8. Appareil de mesure selon l'une des revendications 1 à 7,
**caractérisé**
**en ce que** le dispositif d'affichage (2) est un écran tactile, et
**en ce que** la sélection et le positionnement des diagrammes de prévisualisation (11, 12, 13, 14) sur le dispositif d'affichage (2) sont effectués par contact tactile et déplacement des diagrammes de prévisualisation (11, 12, 13, 14) .

9. Appareil de mesure selon la revendication 8,
**caractérisé**
**en ce que** l'appareil de mesure (1) est doté d'un instrument pointeur (souris) (5), et
**en ce que** la sélection et le positionnement des diagrammes de prévisualisation (11, 12, 13, 14) sur le dispositif d'affichage (2) sont effectués par sélection et déplacement des diagrammes de prévisualisation (11, 12, 13, 14) au moyen de l'instrument pointeur (5).

10. Appareil de mesure selon la revendication 9,
**caractérisé**
**en ce que** le positionnement des diagrammes (15, 50, 51, 60, 61, 70, 71, 72, 90, 91) est effectué par sélection et déplacement des diagrammes de prévisualisation (11, 12, 13, 14) dans des zones (30, 31, 32, 33, 35, 67, 68, 69, 690, 691) définies du dispositif d'affichage (2) ou dans des zones (30, 31, 32, 33, 35, 67, 68, 69, 690, 691) définies de diagrammes (15, 50, 51, 60, 61, 70, 71, 72, 90, 91) déjà représentés, et
**en ce qu'**un déplacement d'un diagramme de prévisualisation (11, 12, 13, 14) sur le dispositif d'affichage (2) sans représentation préalable d'un diagramme (15, 50, 51, 60, 61, 70, 71, 72, 90, 91) entraîne la représentation d'un diagramme (15, 50, 51, 60, 61, 70, 71, 72, 90, 91) correspondant au diagramme de prévisualisation (11, 12, 13, 14) sur pratiquement l'ensemble du dispositif d'affichage (2).

11. Appareil de mesure selon la revendication 10,
**caractérisé**
**en ce qu'**un déplacement d'un diagramme de prévisualisation (11, 12, 13, 14) vers le milieu (35, 690) d'un premier diagramme (15, 50, 51, 60, 61, 70, 71, 72, 90, 91) déjà représenté entraîne une superposition du premier diagramme (15, 50, 51, 60, 61, 70, 71, 72, 90, 91) et du deuxième diagramme (15, 50, 51, 60, 61, 70, 71, 72, 90, 91) correspondant au diagramme de prévisualisation (11, 12, 13, 14) .

12. Appareil de mesure selon l'une des revendications 1 à 11,
**caractérisé**
**en ce que** la réduction est effectuée de telle manière que la représentation du deuxième diagramme (15, 50, 51, 60, 61, 70, 71, 72, 90, 91) est effectuée sur le côté du bord (30, 31, 32, 33, 67, 68, 69, 691) du premier diagramme (15, 50, 51, 60, 61, 70, 71, 72, 90, 91) vers lequel le diagramme de prévisualisation (11, 12, 13, 14) a été déplacé.

13. Appareil de mesure selon l'une des revendications 1 à 12,
**caractérisé**
**en ce qu'**en cas de représentation d'un diagramme (15, 50, 51, 60, 61, 70, 71, 72, 90, 91), le diagramme de prévisualisation (11, 12, 13, 14) correspondant au diagramme (15, 50, 51, 60, 61, 70, 71, 72, 90, 91) est masqué ou remplacé par des paramètres de configuration.

14. Appareil de mesure selon l'une des revendications 1 à 13,
**caractérisé**
**en ce que** le dispositif d'affichage (2) représente les diagrammes de prévisualisation (11, 12, 13, 14) avec un degré de transparence quelconque fixé par le dispositif de traitement (4), et
**en ce que** le dispositif d'affichage (2) représente les diagrammes de prévisualisation (11, 12, 13, 14) superposés aux diagrammes (15, 50, 51, 60, 61, 70, 71, 72, 90, 91).

15. Appareil de mesure selon l'une des revendications 1 à 14,
**caractérisé**
**en ce que** l'unité de commande (6) de l'appareil de mesure (1) est dotée de plusieurs éléments de commande (7),
**en ce que** les plusieurs éléments de commande (7) peuvent être éclairés et/ou rétro-éclairés avec des couleurs au moins similaires aux couleurs des diagrammes (15, 50, 51, 60, 61, 70, 71, 72, 90, 91),
**en ce qu'**un seul diagramme (15, 50, 51, 60, 61, 70, 71, 72, 90, 91) représenté par l'appareil de mesure (1) est un diagramme (15, 50, 51, 60, 61, 70, 71, 72, 90, 91) actif,
**en ce que** le dernier diagramme (15, 50, 51, 60, 61, 70, 71, 72, 90, 91) placé ou modifié est le diagramme actif (15, 50, 51, 60, 61, 70, 71, 72, 90, 91), et
**en ce qu'**au moins un élément de commande (7) est éclairé ou rétro-éclairé avec une couleur au moins similaire à la couleur du diagramme actif (15, 50, 51, 60, 61, 70, 71, 72, 90, 91).

16. Appareil de mesure selon la revendication 15,
**caractérisé**
**en ce que** le diagramme actif (15, 50, 51, 60, 61, 70, 71, 72, 90, 91) est changé par sélection d'un diagramme (15, 50, 51, 60, 61, 70, 71, 72, 90, 91) sur le dispositif d'affichage (2), et
**en ce que** le changement du diagramme actif (15, 50, 51, 60, 61, 70, 71, 72, 90, 91) change l'éclairage ou le rétro-éclairage d'au moins un élément de commande (7) vers une couleur similaire à la couleur du diagramme actif (15, 50, 51, 60, 61, 70, 71, 72, 90, 91).

17. Procédé de mesure avec un appareil de mesure (1),
dans lequel l'appareil de mesure (1) est doté d'un dispositif d'affichage (2), d'un dispositif de traitement (4) et d'au moins un canal de mesure,
dans lequel des signaux de mesure (20, 40, 54, 55, 64, 65, 79, 80, 81, 94) dudit au moins un canal de mesure sont mesurés au moyen du dispositif de traitement (4),
dans lequel le signal de mesure (20, 40, 54, 55, 64, 65, 79, 80, 81, 94) dudit au moins un canal de mesure est représenté sous forme de diagramme (15, 50, 51, 60, 61, 70, 71, 72, 90, 91) au moyen du dispositif d'affichage (2),
dans lequel plusieurs diagrammes (50, 51, 60, 61, 70, 71, 72, 90, 91) peuvent être simultanément représentés,
dans lequel le dispositif d'affichage (2) représente en outre des diagrammes de prévisualisation (11, 12, 13, 14),
dans lequel les diagrammes de prévisualisation (11, 12, 13, 14) sont des représentations en réduction des diagrammes (15, 50, 51, 60, 61, 70, 71, 72, 90, 91),
dans lequel l'appareil de mesure (1) est en outre doté d'une unité de commande (6) avec au moins un élément de commande (7),
dans lequel les plusieurs diagrammes (50, 51, 60, 61, 70, 71, 72, 90, 91) sont représentés superposés et/ou juxtaposés et/ou l'un au-dessous de l'autre,
dans lequel les plusieurs diagrammes (50, 51, 60, 61, 70, 71, 72, 90, 91) sont représentés à des emplacements différents du dispositif d'affichage (2),
et dans lequel les diagrammes (15, 50, 51, 60, 61, 70, 71, 72, 90, 91) sont agencés sur le dispositif d'affichage (2) par positionnement des diagrammes de prévisualisation (11, 12, 13, 14) dans des zones (30, 31, 32, 33, 35, 67, 68, 69, 690, 691) définies du dispositif d'affichage (2),
**caractérisé**
**en ce que** chaque diagramme (15, 50, 51, 60, 61, 70, 71, 72, 90, 91) représenté est représenté dans une couleur différenciable des couleurs des représentations des autres diagrammes (15, 50, 51, 60, 61, 70, 71, 72, 90, 91),
**en ce que** ledit au moins un élément de commande (7) est éclairé et/ou rétro-éclairé avec des couleurs au moins similaires aux couleurs des diagrammes (15, 50, 51, 60, 61, 70, 71, 72, 90, 91),
et **en ce qu'**un déplacement d'un diagramme de prévisualisation (11, 12, 13, 14) sur le bord (30, 31, 32, 33, 67, 68, 69, 691) d'un premier diagramme (15, 50, 51, 60, 61, 70, 71, 72, 90, 91) déjà représenté entraîne une réduction du premier diagramme (15, 50, 51, 60, 61, 70, 71, 72, 90, 91) et une représentation du deuxième diagramme (15, 50, 51, 60, 61, 70, 71, 72, 90, 91) correspondant au diagramme de prévisualisation (11, 12, 13, 14) sur la surface libérée par la réduction.

18. Procédé de mesure selon la revendication 17,
**caractérisé**
**en ce que** plusieurs diagrammes (15, 50, 51, 60, 61, 70, 71, 72, 90, 91) peuvent être déduits du signal de mesure (20, 40, 54, 55, 64, 65, 79, 80, 81, 94) dudit au moins un canal de mesure.

19. Procédé de mesure selon la revendication 17 ou 18,
**caractérisé**
**en ce que** plusieurs signaux de mesure (20, 40, 54, 55, 64, 65, 79, 80, 81, 94) de plusieurs canaux de mesure peuvent être mesurés.

20. Procédé de mesure selon la revendication 19,
**caractérisé**
**en ce qu'**un signal de mesure (20, 40, 54, 55, 64, 65, 79, 80, 81, 94) peut être déduit simultanément des signaux de mesure (20, 40, 54, 55, 64, 65, 79, 80, 81, 94) de plusieurs canaux de mesure.

21. Procédé de mesure selon l'une des revendications 17 à 20,
**caractérisé**
**en ce que** les diagrammes de prévisualisation (11, 12, 13, 14) sont masqués si besoin.

22. Procédé de mesure selon la revendication 21,
**caractérisé**
**en ce que** les diagrammes de prévisualisation (11, 12, 13, 14) sont des représentations simplifiées des diagrammes (15, 50, 51, 60, 61, 70, 71, 72, 90, 91), et
**en ce que** les diagrammes de prévisualisation (11, 12, 13, 14) sont des images en temps réel des diagrammes (15, 50, 51, 60, 61, 70, 71, 72, 90, 91).

23. Procédé de mesure selon la revendication 21 ou 22,
**caractérisé**
**en ce que** les diagrammes (15, 50, 51, 60, 61, 70, 71, 72, 90, 91) à représenter sont sélectionnés par sélection des diagrammes de prévisualisation (11, 12, 13, 14) correspondants, et
**en ce qu'**une nouvelle sélection d'un diagramme de prévisualisation (11, 12, 13, 14), en cas de représentation déjà effectuée du diagramme (15, 50, 51, 60, 61, 70, 71, 72, 90, 91) correspondant, supprime le diagramme (15, 50, 51, 60, 61, 70, 71, 72, 90, 91) correspondant du dispositif d'affichage (2).

24. Procédé de mesure selon l'une des revendications 17 à 23,
**caractérisé**
**en ce que** le dispositif d'affichage (2) est un écran tactile, et
**en ce que** les diagrammes de prévisualisation (11, 12, 13, 14) sont sélectionnés et positionnés sur le dispositif d'affichage (2) par contact tactile et déplacement.

25. Procédé de mesure selon l'une des revendications 17 à 24,
**caractérisé**
**en ce que** l'appareil de mesure est doté d'un instrument pointeur (souris) (5), et
**en ce que** les diagrammes de prévisualisation (11, 12, 13, 14) sont positionnés sur le dispositif d'affichage (2) par sélection et déplacement au moyen de l'instrument pointeur (5) .

26. Procédé de mesure selon la revendication 25,
**caractérisé**
**en ce que** les diagrammes (15, 50, 51, 60, 61, 70, 71, 72, 90, 91) sont positionnés par sélection et déplacement des diagrammes de prévisualisation (11, 12, 13, 14) dans des zones (30, 31, 32, 33, 35, 67, 68, 69, 690, 691) définies du dispositif d'affichage (2) ou dans des zones (30, 31, 32, 33, 35, 67, 68, 69, 690, 691) définies de diagrammes (15, 50, 51, 60, 61, 70, 71, 72, 90, 91) déjà représentés, et
**en ce qu'**un déplacement d'un diagramme de prévisualisation (11, 12, 13, 14) sur le dispositif d'affichage (2) sans représentation préalable d'un diagramme (15, 50, 51, 60, 61, 70, 71, 72, 90, 91) entraîne la représentation d'un diagramme (15, 50, 51, 60, 61, 70, 71, 72, 90, 91) correspondant au diagramme de prévisualisation (11, 12, 13, 14) sur pratiquement l'ensemble du dispositif d'affichage (2).

27. Procédé de mesure selon la revendication 26,
**caractérisé**
**en ce qu'**un déplacement d'un diagramme de prévisualisation (11, 12, 13, 14) vers le milieu (35, 690) d'un premier diagramme (15, 50, 51, 60, 61, 70, 71, 72, 90, 91) déjà représenté entraîne une superposition du premier diagramme (15, 50, 51, 60, 61, 70, 71, 72, 90, 91) et du deuxième diagramme (15, 50, 51, 60, 61, 70, 71, 72, 90, 91) correspondant au diagramme de prévisualisation (11, 12, 13, 14) .

28. Procédé de mesure selon la revendication 26 ou 27,
**caractérisé**
**en ce que** la réduction est effectuée de telle manière que la représentation du deuxième diagramme (15, 50, 51, 60, 61, 70, 71, 72, 90, 91) est effectuée sur le côté du bord (30, 31, 32, 33, 67, 68, 69, 691) du premier diagramme (15, 50, 51, 60, 61, 70, 71, 72, 90, 91) vers lequel le diagramme de prévisualisation (11, 12, 13, 14) a été déplacé.

29. Procédé de mesure selon l'une des revendications 17 à 28,
**caractérisé**
**en ce qu'**en cas de représentation d'un diagramme (15, 50, 51, 60, 61, 70, 71, 72, 90, 91), le diagramme de prévisualisation (11, 12, 13, 14) correspondant au diagramme (15, 50, 51, 60, 61, 70, 71, 72, 90, 91) est masqué ou remplacé par des paramètres de configuration.

30. Procédé de mesure selon l'une des revendications 17 à 29,
**caractérisé**
**en ce que** les diagrammes de prévisualisation (11, 12, 13, 14) sont affichés transparents, et
**en ce que** les diagrammes de prévisualisation (11, 12, 13, 14) sont affichés superposés aux diagrammes (15, 50, 51, 60, 61, 70, 71, 72, 90, 91).

31. Procédé de mesure selon l'une des revendications 17 à 30,
**caractérisé**
**en ce que** l'unité de commande (6) de l'appareil de mesure (1) est dotée de plusieurs éléments de commande (7),
**en ce que** les plusieurs éléments de commande (7) peuvent être éclairés et/ou rétro-éclairés avec des couleurs au moins similaires aux couleurs des diagrammes (15, 50, 51, 60, 61, 70, 71, 72, 90, 91),
**en ce qu'**un seul diagramme (15, 50, 51, 60, 61, 70, 71, 72, 90, 91) représenté par l'appareil de mesure (1) est un diagramme (15, 50, 51, 60, 61, 70, 71, 72, 90, 91) actif,
**en ce que** le dernier diagramme (15, 50, 51, 60, 61, 70, 71, 72, 90, 91) placé ou modifié est le diagramme actif (15, 50, 51, 60, 61, 70, 71, 72, 90, 91), et
**en ce qu'**au moins un élément de commande (7) est éclairé ou rétro-éclairé avec une couleur au moins similaire à la couleur du diagramme actif (15, 50, 51, 60, 61, 70, 71, 72, 90, 91).

32. Procédé de mesure selon la revendication 31,
**caractérisé**
**en ce que** le diagramme actif (15, 50, 51, 60, 61, 70, 71, 72, 90, 91) est changé par sélection d'un diagramme (15, 50, 51, 60, 61, 70, 71, 72, 90, 91) sur le dispositif d'affichage (2), et
**en ce que** le changement du diagramme actif (15, 50, 51, 60, 61, 70, 71, 72, 90, 91) change l'éclairage ou le rétro-éclairage d'au moins un élément de commande (7) vers une couleur similaire à la couleur du diagramme actif (15, 50, 51, 60, 61, 70, 71, 72, 90, 91).
